# EUROPEAN PATENT APPLICATION

(11) **EP 4 661 319 A1**
(43) Date of publication of application: **10.12.2025**
(21) Application number: 25180593.3
(22) Date of filing: 03.06.2025
(51) Int. Cl.: H04B 10/69, H04B 10/40

(54) **RECEIVER MONITORING IN LINEAR RECEIVER OPTICS**

(30) Priority: 03.06.2024 US 202463655498 P; 22.10.2024 US 202463710503 P
(71) Applicant: Cisco Technology, Inc., San Jose, CA 95134-1706 (US)
(72) Inventor: Parvizi, Mahdi, San Jose, 95134-1706 (US); Heimbuch, Mark, San Jose, 95134-1706 (US); Aroca, Ricardo A., San Jose, 95134-1706 (US); Williams, Tom, San Jose, 95134-1706 (US); Giannakopoulos, Dimitrios, San Jose, 95134-1706 (US)
(74) Representative: Noble, Nicholas

(57) **Abstract**

An optical receiver and a linear receiver pluggable optics (LRO) module are disclosed. The optical receiver includes a photodiode, a transimpedance amplifier (TIA), and a variable gain stage with multiple amplifiers. The optical receiver features dual output buffers for signal distribution to a HOST serializer/deserializer and a re-timer or digital signal processor (DSP). A switch controls the second output buffer without causing bit errors. The LRO module connects to a remote transmitter and includes a photodiode, TIA, and DSP for signal processing. The optical receiver supports advanced monitoring and testing through multiple test points. The module's design ensures efficient signal conversion and transmission, with the ability to toggle re-timers without introducing errors. The system is designed for high-performance optical communication, offering flexibility and reliability in signal handling and processing.

## Description

### CROSS-REFERENCE TO RELATED APPLICATIONS

This application claims benefit of co-pending United States provisional patent applications Serial No. 63/655,498 filed June 3, 2024 and Serial No. 63/710,503 filed October 22, 2024. The aforementioned related patent applications are herein incorporated by reference in their entirety.

### TECHNICAL FIELD

This disclosure relates generally to optical transceivers, specifically linear receiver pluggable optics.

### BACKGROUND

The linear-drive approach in linear pluggable optics streamlines transceiver design by omitting the digital signal processor and clock data recovery integrated circuit components. The functions of these integrated circuits are consolidated within the switch integrated circuit in the HOST device. The high-linearity driver integrated circuit and transimpedance amplifier (TIA) remain on the transceiver.

### BRIEF DESCRIPTION OF THE DRAWINGS

Unless specified otherwise, the accompanying drawings illustrate aspects of the innovations described herein. Referring to the drawings, wherein like numerals refer to like parts throughout the several views and this specification, several embodiments of presently disclosed principles are illustrated by way of example, and not by way of limitation. The drawings are not intended to be drawn to scale. A more complete understanding of the disclosure may be realized by reference to the accompanying drawings in which:
FIG. 1 illustrates conventional re-timed pluggable optics, linear receiver pluggable optics (LRO), and linear pluggable optics (LPO).
FIG. 2 illustrates a linear receiver optics (LRO) module with test points TP1-TP4, according to an embodiment of this disclosure.
FIG. 3 illustrates an LRO module configured to monitor the trans-impedance amplifier (TIA) output TP4 in the electrical domain, according to an embodiment of this disclosure.
FIG. 4 is an optical detector with a single-ended photodiode, according to an embodiment of this disclosure.
FIG. 5 is an optical detector with a differential photodiode, according to an embodiment of this disclosure.
FIG. 6 illustrates different types of optical modules, according to embodiments of this disclosure.
FIG. 7 illustrates a re-timer (DSP) block diagram in mission mode configuration, according to an embodiment of this disclosure.
FIG. 8 illustrates the LRO architecture, according to an embodiment of the present disclosure.
FIG. 9 illustrates a configuration of the re-timer, according to an embodiment of the present disclosure.
FIG. 10 illustrates the enabled paths through the re-timer in the LRO architecture, according to an embodiment of the present disclosure.
FIG. 11 illustrates a re-timer configured for HOST side and line side monitoring, according to an embodiment of the present disclosure.
FIG. 12 illustrates the LRO architecture of HOST side and line side monitoring, according to an embodiment of the present disclosure.
Figure 13 illustrates a line loopback configuration of the re-timer, according to an embodiment of the present disclosure.
FIG. 14 illustrates the LRO architecture of line loopback configuration, according to an embodiment of the present disclosureFigure1...

### DESCRIPTION OF EXAMPLE EMBODIMENTS

### OVERVIEW

In part, in one aspect, the disclosure relates to an optical receiver comprising a photodiode, a transimpedance amplifier (TIA) having an input coupled to an output of the photodiode, and a variable gain stage coupled to an output of the TIA. The variable gain stage comprising a plurality of variable gain amplifiers. The optical receiver comprising a first output buffer coupled to the variable gain stage to output a signal to a first module and a second output buffer coupled to the variable gain stage to output the signal to a second module.

In part, in one aspect, the disclosure relates to a linear receiver pluggable optics (LRO) module comprising a transmitter to receive an electrical signal. The transmitter comprising, a digital signal processor (DSP) module, a driver coupled to an output of the DSP module, and a modulator coupled to an output of the driver, wherein the modulator is configured to output an optical signal. The LRO comprising a receiver coupled to the transmitter. The receiver comprising a photodiode to receive the optical signal, a transimpedance amplifier (TIA) module coupled to an output of the photodiode to transform the optical signal to the electrical signal. The TIA module comprises a first output to output a signal to a HOST serializer/deserializer (SerDes) and a second output to output the signal to the DSP module.

### EXAMPLE EMBODIMENTS

This disclosure is directed to the optical communications sector, driven by the demands of 5G and High-Performance Computing (HPC). Data center networks are incrementally scaling from 400G to 800G, advancing towards 1.6T, and are anticipated to reach speeds of 3.2T and beyond. As data center network capacities expand there is a corresponding push to increase the transmission speeds of optical modules. Beyond the desire for speed enhancements, optical transceivers can be improved in energy efficiency and form factor.

The linear-drive approach in linear pluggable optics (LPO) streamlines the transceiver design by omitting the digital signal processor (DSP) and clock data recovery (CDR) integrated circuit components. The functions of these integrated circuit components are consolidated within the switch integrated circuit in the HOST device. The high-linearity driver integrated circuit and transimpedance amplifier (TIA) remain on the transceiver. The transceiver may comprise additional features such as continuous time linear equalization (CTLE) and signal equalization (EQ) integrated into the TIA and/or driver to provide some compensation for high-speed signals. LPO leads to lower power consumption, lower latency, and cost. LPO is challenging at high speeds of 100Gb/s and beyond due to crosstalk and component and interconnect process variations.

To ease performance issues, an intermediate solution called linear receiver optics (LRO) is provided, where the re-timer is eliminated only at the receiver (Rx) and it is maintained in the transmitter (Tx) to improve performance of the LPO at high data rates, especially at data rates above 200Gb/s.

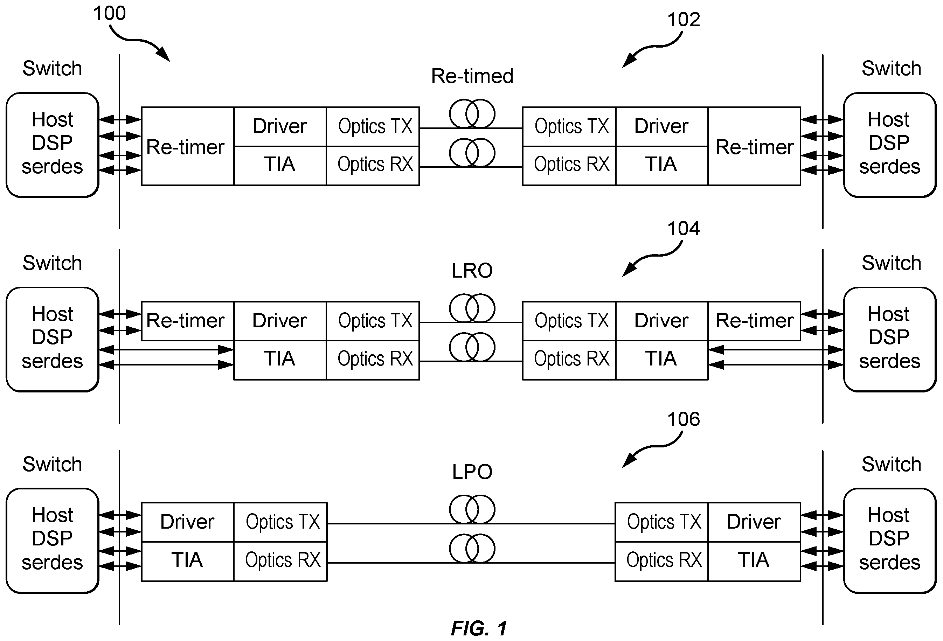

FIG. 1 illustrates conventional re-timed pluggable optics, linear receiver pluggable optics (LRO), and linear pluggable optics (LPO). FIG. 1 illustrates different types of conventional optical modules 100. For example, re-timed pluggable optics 102 include an optical transmitter (Tx) to transmit optical signals and an optical receiver (Rx) to receive optical signals. The optical transmitter is coupled to a driver to drive the electrical signal. The optical receiver is coupled to a TIA to transform the optical signal into an electrical signal. A re-timer is coupled between the TIA and the driver. The re-timer is further coupled to a HOST SerDes.

For example, a first module of the re-timed optics 102 comprises an optical transmitter and a driver coupled to the optical transmitter. The re-timed optics 102 (e.g., a module) comprises an optical receiver and a TIA coupled to the output of the optical receiver. Between the TIA and the driver, a re-timer is coupled. The re-timer is further coupled to a HOST SerDes (signal serializer and deserializer). The first module is coupled to a second module. The second module comprises the same components and operates in the same way.

For example, linear receivable pluggable optics 104 (LRO) include an optical transmitter (Tx) to transmit optical signals and an optical receiver (Rx) to receive optical signals. The optical transmitter is coupled to a driver to drive the optical signal. The optical receiver is coupled to a TIA to transform the optical signal into an electrical signal. A re-timer is coupled to the TIA and driver.

For example, a LRO 104 comprises a first module. The first module comprises an optical transmitter and a driver coupled to the optical transmitter. The LRO 104 (e.g., a LRO module) comprises an optical receiver and a TIA coupled to the output of the optical receiver. A re-timer is coupled to the output of the driver. The re-timer and TIA are further coupled to a HOST SerDes. The first module is coupled to a second module of the LRO 104. The second module comprises the same components and operates in the same way.

For example, linear pluggable optics (LPO) 106 include an optical transmitter (Tx) to transmit optical signals and an optical receiver (Rx) to receive optical signals. The optical transmitter is coupled to a driver to drive the optical signal. The optical receiver is coupled to a TIA to transform the optical signal into an electrical signal. No re-timer is included in the LPO 106.

For example, a LPO 106 comprises a first module. The first module comprises an optical transmitter and a driver coupled to the optical transmitter. The LPO 106 comprises an optical receiver and a TIA coupled to the output of the optical receiver. The driver and TIA are further coupled to a host SerDes. The first module is coupled to a second module of the LPO. The second module comprises the same components and operates in the same way.

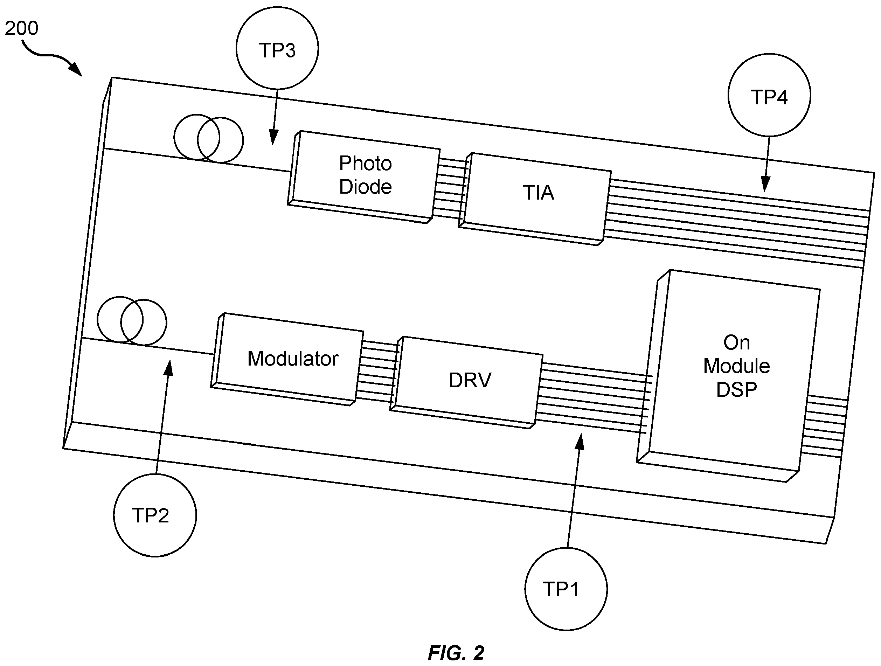

FIG. 2 illustrates a linear receiver optics (LRO) module with test points TP1-TP4, according to an embodiment of this disclosure. In particular, FIG. 2 illustrates a module of the LRO module 200, according to an embodiment of this disclosure. The LRO module 200 comprises the same elements as shown in the first or second module of the LRO 104 in FIG. 1. The on-module digital signal processor (DSP) comprises the re-timer. The on-module DSP receives the electrical signal from a DSP SerDes and sends the electrical signal to the driver. The driver is coupled to a modulator to transform the signal into an optical signal and transmit the optical signal through an optical cable. The on module-DSP, driver, and modulator comprise the transmitter on the LRO module 200.

A photodiode receives the optical signal from a remote transmitter and generates a current proportional to the amount of light received by the photodiode. The TIA transforms the current to a voltage proportional to the amount of current created by the photodiode. The photodiode and the TIA comprise the receiver on the LRO module 200. The electrical signal may be transmitted to a HOST SerDes as shown in FIG. 1.

The LRO module 200 comprises four test points. The first test point (TP1) is in the electrical domain and is coupled between the driver and the DSP. The second test point (TP2) is in the optical domain and is coupled to the output of the modulator. The third test point (TP3) is in the optical domain and is coupled to the input of the photodiode. The fourth test point (TP4) is in the electric domain and is coupled to the output of the TIA.

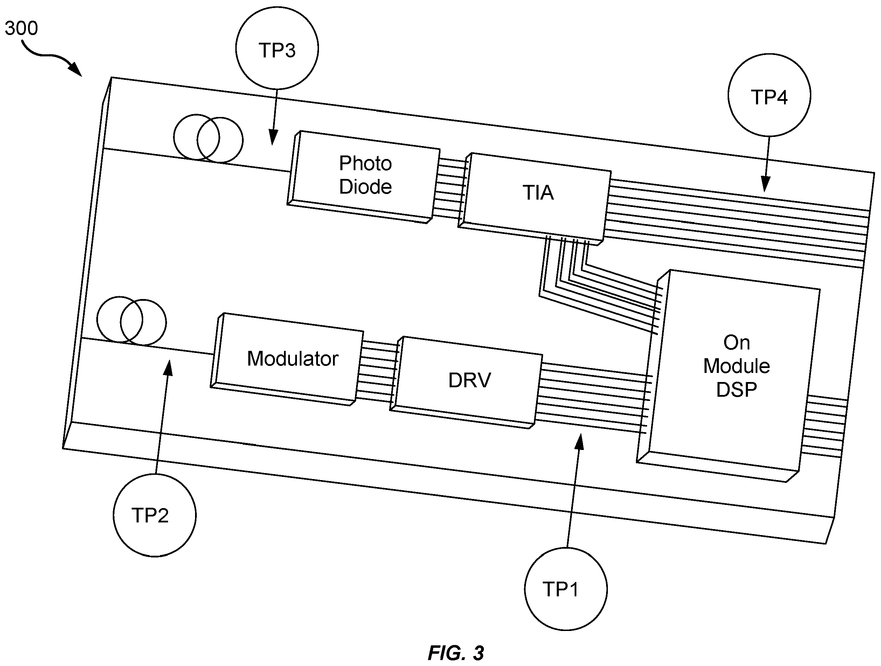

FIG. 3 illustrates an LRO module configured to monitor the trans-impedance amplifier (TIA) output TP4 in the electrical domain, according to an embodiment of this disclosure. The LRO module 300 comprises the same elements as shown in the LRO 104 in FIG. 1. The on-module DSP comprises the re-timer. The on-module DSP receives the electrical signal from a DSP SerDes and sends the electrical signal to the driver. The driver is coupled to a modulator to transform the signal into an optical signal and transmit the optical signal through an optical cable. The on module-DSP, driver, and modulator comprise the transmitter on the LRO module 300.

A photodiode receives the optical signal from a remote transmitter and generates a current proportional to the amount of light received by the photodiode. The TIA transforms the current to a voltage proportional to the amount of current created by the photodiode. The photodiode and the TIA comprise the receiver on the LRO module 300. The electrical signal may be transmitted to a HOST SerDes as shown in FIG. 1.

The LRO module 300 comprises four test points. The first test point (TP1) is in the electrical domain and is coupled between the driver and the DSP. The second test point (TP2) is in the optical domain and is coupled to the output of the modulator. The third test point (TP3) is in the optical domain and is coupled to the input of the photodiode. The fourth test point (TP4) is in the electric domain and is coupled to the output of the TIA.

The LRO module 300 further comprises a second output from the TIA to the on-module DSP. The second output to the on-module DSP can monitor the signal at the TIA output in a test mode and in mission mode. The second output is coupled to a receiver re-timer on the DSP module. The in-module monitoring points enable productization of LRO solution for 100Gb/s and beyond with advanced monitoring capabilities. The LRO application comprises a re-timer on the transmitter within the DSP. The DSP comprises a receiver re-timer in the DSP as well. The second output from the TIA is provided to the receiver re-timer in the DSP.

Each channel of the first output has a separate second channel on the second output which makes monitoring of all the channels simultaneously possible. The receiver re-timer samples the electrical signal at the output of the TIA inside the module and is able to provide the EECQ (electrical eye closure quaternary) number.

The receiver re-timer can be configured to turn on to analyze the quality of the signal at the TIA output.

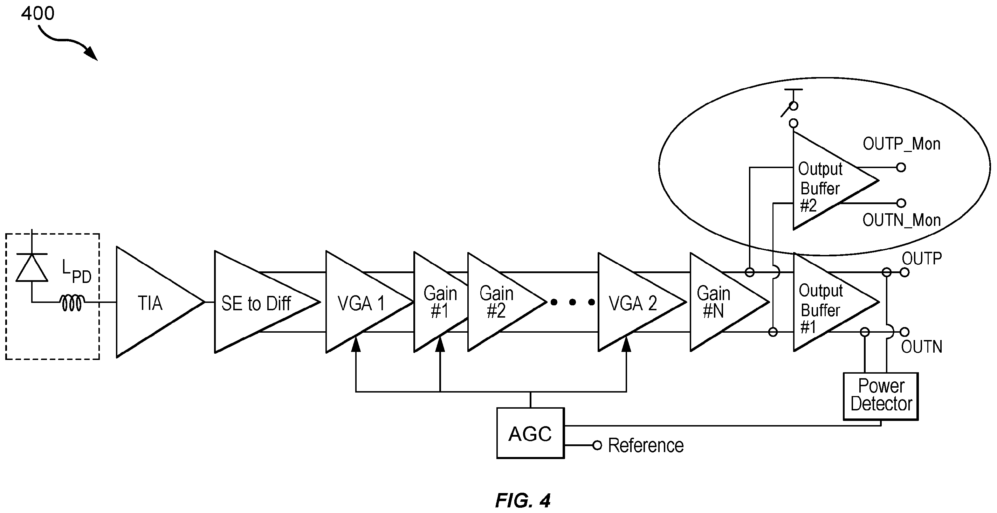

FIG. 4 is an optical detector with a single-ended photodiode, according to an embodiment of this disclosure. The optical detector 400 comprises a photodiode where one end of the photodiode is coupled to the TIA. The photodiode is a single-ended photodiode for single-ended intensity-modulation direct detection (IMDD) detector, where laser light is intensity modulated by incoming radio-frequency (RF) radiation, propagated through a fiber-optic span, and then demodulated back to an RF current with a photodiode.

The optical detector 400 comprises a first photodiode coupled to an inductor. The inductor is coupled to a TIA. The photodiode is configured to detect light and output a current proportional to the amount of light incident on the photodiode.

The TIA is configured to transform the current from the photodiode to a voltage proportional to the current. The TIA is coupled to a buffer. The buffer may be a single ended (SE) to differential buffer. The buffer is communicatively coupled to a variable gain stage. The variable gain stage comprises a plurality of variable gain amplifiers (VGA) to vary the gain of the signal. The variable gain stage outputs a signal to the first output buffer. The first output buffer buffers the signal to an output signal and sends the signal to a HOST SerDes (as shown in FIG. 1).

The variable gain stage is also coupled to a second output buffer. The second output buffer is coupled to a switch. The switch is coupled to a voltage source. The switch is configured to turn the buffer on and off. The second output buffer is coupled to the on-module DSP (shown in FIG. 3).

The optical detector 400 further comprises a gain feedback control circuit. The gain feedback control circuit is a feedback loop. The gain feedback control circuit is coupled to an output of the output buffer. The output signal from the output buffer is input to a power detector to detect a power at the output of the optical detector 400. The signal is sent to the automatic gain control circuit (AGC). The AGC compares the output signal with a reference voltage. The reference voltage may set the signal levels at the TIA output. The AGC is coupled to the variable gain amplifiers. The AGC outputs a gain control signal based on the comparison. The gain control signal is sent to the gain stage. The feedback loop is configured to generate a gain control signal. The gain control signal may be based on a reference voltage and a voltage at an output of the optical detector. The gain control signal may be based on a feedback loop to compare a reference voltage with an output voltage of the optical detector. The AGC is coupled to the second stage and the variable gain amplifiers.

The TIA module shown in FIG. 3 may comprise the TIA, buffer, variable gain stage, output buffers, and the gain feedback control circuit shown in FIG. 4.

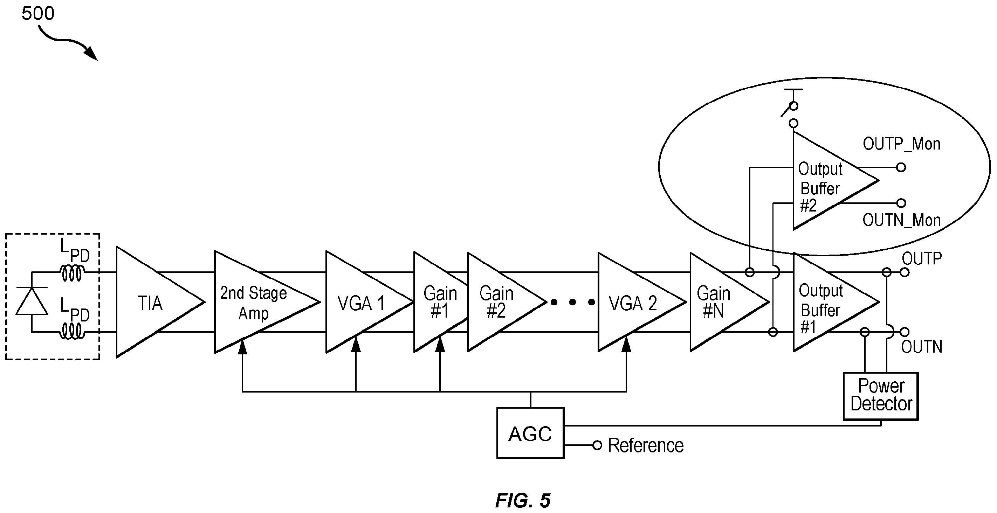

FIG. 5 is an optical detector with a differential photodiode, according to an embodiment of this disclosure. The optical detector 500 comprises a photodiode, where each end of the photodiode is coupled to the TIA. The photodiode may be a differential photodiode. The optical detector 500 may be a differential IMDD detector.

The optical detector 500 comprises a first photodiode coupled to an inductor. The inductor is coupled to a TIA. The photodiode is configured to detect light and output a current proportional to the amount of light incident on the photodiode.

The TIA is configured to transform the current from the photodiode to a voltage proportional to the current. The TIA is coupled to a buffer. The buffer may be a single ended (SE) to differential buffer. The buffer is communicatively coupled to a variable gain stage. The variable gain stage comprises a plurality of variable gain amplifiers (VGA) to vary the gain of the signal. The variable gain stage outputs a signal to the first output buffer. The first output buffer buffers the signal to an output signal and sends the signal to a HOST SerDes (as shown in FIG. 1).

The variable gain stage is also coupled to a second output buffer. The second output buffer is coupled to a switch. The switch is coupled to a voltage source. The switch is configured to turn the buffer on and off. The second output buffer is coupled to the on-module DSP.

The optical detector 500 further comprises a gain feedback control circuit. The gain feedback control circuit is a feedback loop. The gain feedback control circuit is coupled to an output of the first output buffer (#1). The output signal from the output buffer is input to a power detector to detect a power at the output of the optical detector 500. The signal is sent to the automatic gain control circuit (AGC). The AGC compares the output signal with a reference voltage. The reference voltage may set the signal levels at the TIA output. The AGC is coupled to the variable gain amplifiers. The AGC outputs a gain control signal based on the comparison. The gain control signal is sent to the gain stage. The feedback loop is configured to generate a gain control signal. The gain control signal may be based on a reference voltage and a voltage at an output of the optical detector. The gain control signal may be based on a feedback loop to compare a reference voltage with an output voltage of the optical detector. The AGC is coupled to the second stage and the variable gain amplifiers.

The TIA module shown in FIG. 3 may comprise the TIA, buffer, variable gain stage, output buffers, and the gain feedback control circuit shown in FIG. 5.

Referring to both FIGs. 4 and 5, the second output buffer is substantially the same and operates in substantially the same way. The second output buffer comprises an output that follows the output of the first output buffer because the input to the second output buffer is inside the AGC loop. The output from the second output buffer follows the amplitude of the output from the first output buffer. The second output buffer does not generate a burst error when the switch switches the second buffer on and off, and an additional signal may be sent to the DSP so that the DSP also switches on and off its advanced monitoring functions to preserve power.

The second output buffer is configured to be switched on and off to save power via the switch. The switch may also enable an ultra-low power mode. The switch may then enable a high-power mode, a low-power mode, and/or a power saving state (which approaches original mission mode power). In some embodiments, the output buffer does not comprise a switch and has multiple modes, e.g., high-power mode, a low-power mode, and/or a power saving state (which approaches original mission mode power). The multiple modes may comprise multiple power states between off and on. For example, a control circuit coupled to at least one switch may digitally configure multiple power states between on and off.

The second output buffer also comprises an adjustable output impedance to match multiple impedances.

The second output buffer, when turned on during mission mode, does not introduce bit errors. Mission mode may be the operational mode and not a test mode.

The second output buffer outputs the electrical signal from the variable gain stage to the re-timer in the DSP on the module, such as the LRO module 300 shown in FIG. 3. The DSP may sample the signal at a baud rate and can equalize the signal both in analog and digital domain. The DSP can provide any data needed by standards, e.g., EECQ. This allows monitoring of the signal quality at the TIA output and TP4 monitoring point to aid in productization of LRO in 100Gb/s and beyond.

Examples of the devices disclosed herein, according to various aspects of the present disclosure, are provided below in the following embodiments. An aspect of the devices may include any one or more than one of, and any combination of, the embodiments described below.

In a first embodiment, the present disclosure provides an optical receiver including a photodiode; a transimpedance amplifier (TIA) having an input coupled to an output of the photodiode; a variable gain stage coupled to an output of the TIA. The variable gain stage includes a plurality of variable gain amplifiers. The optical receiver further includes a first output buffer coupled to the variable gain stage to output a signal to a first module; and a second output buffer coupled to the variable gain stage to output the signal to a second module.

Additionally, in the first embodiment, the photodiode includes a first end coupled to the TIA; or the photodiode includes a second end coupled to the TIA, or any combination thereof.

Alternatively, the first embodiment includes a voltage source and a switch coupled between the second output buffer and the voltage source, the switch is configured to switch the second output buffer on and off; or the switch does not introduce bit errors in mission mode; or any combination thereof.

Alternatively, in the first embodiment, the first module is a HOST Serdes; the second module is a re-timer; the second module includes a digital signal processor (DSP) to sample the signal from the second output buffer; or the optical receiver does not include a re-timer; or any combination thereof.

In a second embodiment, the present disclosure provides a linear receiver pluggable optics (LRO) module including a transmitter to receive an electrical signal. The transmitter includes a digital signal processor (DSP) module; a driver coupled to an output of the DSP module; and a modulator coupled to an output of the driver, the modulator is configured to output an optical signal. The linear receiver pluggable optics (LRO) module further includes a receiver coupled to the transmitter. The receiver includes a photodiode to receive the optical signal; a transimpedance amplifier (TIA) module coupled to an output of the photodiode to transform the optical signal to the electrical signal. The TIA module includes a first output to output a signal to a HOST serializer/deserializer (SerDes); and a second output to output the signal to the DSP module.

Additionally, in the second embodiment, the TIA module includes a transimpedance amplifier (TIA) coupled to an output of the photodiode; a variable gain stage coupled to the output of the TIA, the variable gain stage includes a plurality of variable gain amplifiers; a first output buffer coupled between the variable gain stage and the first output; and a second output buffer coupled between the variable gain stage and the second output; the photodiode includes a first end coupled to the TIA; or the photodiode includes a second end coupled to the TIA; or any combination thereof.

Alternatively, in the second embodiment, the TIA module includes a transimpedance amplifier (TIA) coupled to an output of the photodiode; a variable gain stage coupled to the output of the TIA, the variable gain stage includes a plurality of variable gain amplifiers; a first output buffer coupled between the variable gain stage and the first output; and a second output buffer coupled between the variable gain stage and the second output; includes a voltage source and a switch coupled between the second output buffer and the voltage source, the switch is configured to switch the second output buffer on and off; or the switch does not introduce bit errors in mission mode; or any combination thereof.

Alternatively, the second embodiment includes a first test point called between the driver and the DSP module; a second test point coupled to an output of the modulator; a third test point coupled to an input of the photodiode; and a fourth test point coupled to an output of the TIA; the DSP module includes a transmitter re-timer and a receiver re-timer, the receiver re-timer is configured to be turned on and off, the receiver re-timer is coupled to the second output; or the receiver does not include a re-timer.

The disclosure is directed to a method for supporting a RTLR/LRO system that reduces the power footprint of the overall system, while also providing enhanced monitoring capabilities in both transmission directions.

One way to accomplish Network/data center connectivity is via client optics, typically complying to IEEE-802.3 standards that specify electrical and optical parameters which enable very high-speed data transfers using Ethernet technology. To achieve these very high speeds, system integrators frequently use fiber optics as the transmission medium, but the concepts described in this disclosure are not limited to Ethernet technologies or a specific medium.

A HOST device (such as a switch or router chip) with Signal Processing capabilities is sourcing the client traffic (for example Ethernet signals) to an optical module. In the case of an optical connection, the optical module comprises of a DSP IC (ASIC) and optical components (such as TIAs, drivers, PDs etc.).

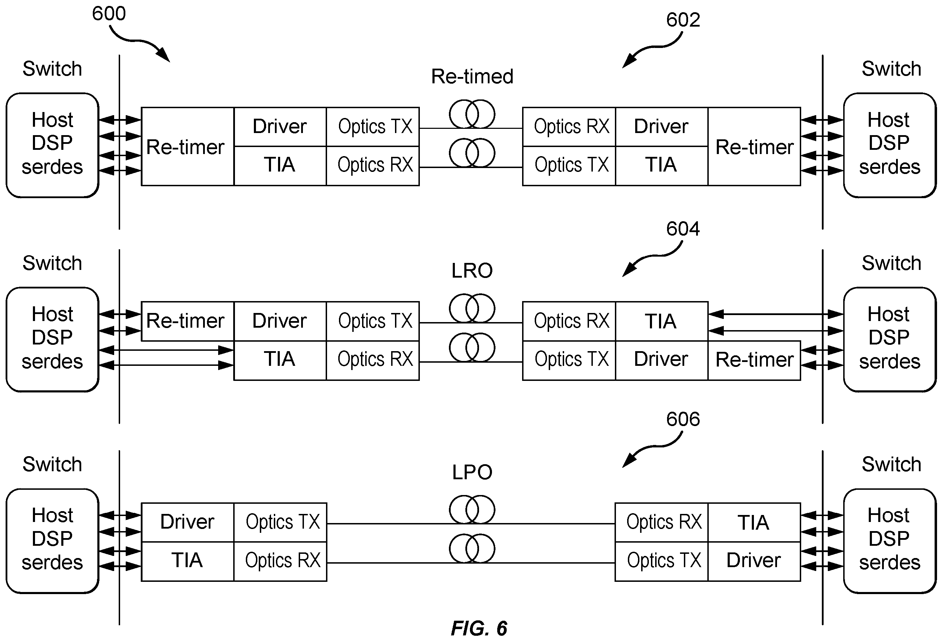

There are different design approaches on how to implement such a system, especially as it pertains to the DSP ICs used in the application as shown in FIG. 6. FIG. 6 illustrates re-timed pluggable optics, linear receiver pluggable optics (LRO), and linear pluggable optics (LPO). FIG. 6 illustrates different types of conventional optical modules 600. For example, re-timed pluggable optics 602 include an optical transmitter (Tx) to transmit optical signals and an optical receiver (Rx) to receive optical signals. The optical transmitter is coupled to a driver to drive the electrical signal. The optical receiver is coupled to a TIA to transform the optical signal into an electrical signal. A re-timer is coupled between the TIA and the driver.

For example, a first module of the re-timed optics 602 comprises an optical transmitter and a driver coupled to the optical transmitter. The re-timed optics 602 (e.g., a module) comprises an optical receiver and a TIA coupled to the output of the optical receiver. Between the TIA and the driver, a re-timer is coupled. The re-timer is further coupled to a HOST SerDes (signal serializer and deserializer). The first module is coupled to a second module. The second module comprises the same components and operates in the same way. The transmitter of the first module is coupled to the receiver of the second module by an optical fiber. The transmitter of the second module is coupled to the receiver of the first module by an optical fiber.

The re-timed optics 602 use a full duplex (bidirectional) DSP ICs, which implement both a transmit and a receive path and the signal is retimed in both directions.

For example, linear receivable pluggable optics 604 (LRO), alternatively called RTLR (Retimed Transmitter Linear Receiver) architecture, include an optical transmitter (Tx) to transmit optical signals and an optical receiver (Rx) to receive optical signals. The optical transmitter is coupled to a driver to drive the optical signal. The optical receiver is coupled to a TIA to transform the optical signal into an electrical signal. A re-timer is coupled between the TIA and driver.

For example, a LRO 604 comprises a first module. The first module comprises an optical transmitter and a driver coupled to the optical transmitter. The module 1 604 comprises an optical receiver and a TIA coupled to the output of the optical receiver. A re-timer is coupled to the output of the driver. The re-timer and TIA are further coupled to a HOST SerDes. The first module is coupled to a second module of the LRO 604. The second module comprises the same components and operates in the same way. The transmitter of the first module is coupled to the receiver of the second module by an optical fiber. The transmitter of the second module is coupled to the receiver of the first module by an optical fiber.

The LRO 604 uses single-direction DSP ICs, which implement only a transmit path.

For example, linear pluggable optics (LPO) 606 include an optical transmitter (Tx) to transmit optical signals and an optical receiver (Rx) to receive optical signals. The optical transmitter is coupled to a driver to drive the optical signal. The optical receiver is coupled to a TIA to transform the optical signal into an electrical signal. No re-timer is included in the LPO 606.

For example, a LPO 606 comprises a first module. The first module comprises an optical transmitter and a driver coupled to the optical transmitter. The re-timed optics 602 comprises an optical receiver and a TIA coupled to the output of the optical receiver. The driver and TIA are further coupled to a HOST SerDes. The first module is coupled to a second module of the LPO. The second module comprises the same components and operates in the same way. The transmitter of the first module is coupled to the receiver of the second module by an optical fiber. The transmitter of the second module is coupled to the receiver of the first module by an optical fiber.

The LPO 606 does not use a DSP IC by integrating just the electrical and optical components.

This disclosure is directed to a variation of the LRO/RTLR architecture, with a single-direction active transmit data path, but with added enhanced monitoring/debug capabilities in the receive path, e.g. an RTLR-Mon architecture.

The systems aim at high-density applications, where many connections are supported and are simultaneously active. At the same time the data transmission speeds keep increasing significantly, and as a result these systems suffer from high power levels (and increasing with new generations of systems).

These systems support pluggable, small sized optical modules, which offer limited space for cooling surfaces. The high-power levels present difficult challenges in cooling down these modules, and the resulting high temperatures can lead to lower quality or even damage of the module components. In addition, costs for electrical power can increase significantly in these situations.

The system includes monitoring capabilities in the receive direction. In an RTLR or LPO architecture, there are no digital monitor circuits in this path that can help the network operators monitor the health of that connection until the signal reaches the HOST device. There is no receive path visibility in the optical module. This does not allow for providing module statistics or detailed information that can help to identify a root cause of any potential issues effectively. This disclosure addresses the issues of both lower power and enhanced monitoring capabilities.

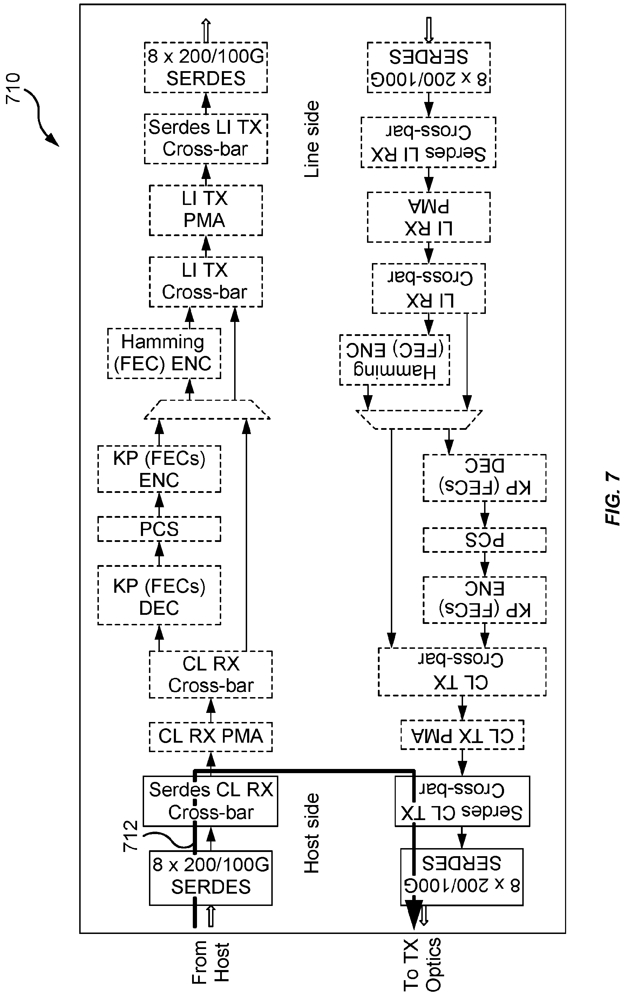

FIG. 7 illustrates a re-timer 710 (DSP) block diagram in mission mode configuration, according to an embodiment of this disclosure. The re-timer 710 block diagram illustrates a bidirectional DSP IC. The HOST input side of the DSP IC is still connected to the HOST (Switch/Router) device, the DSP IC host (client) output side is connected to the optical components on the module network side.

During normal operation, traffic flows in both directions of the system, and the DSP IC has only its transmit path active (from HOST to TX optics). The rest of the DSP IC circuits are powered down or in low power mode (as shown with the dotted boxes), saving power at the system level. In order to maximize power savings, the DSP IC configuration shown in FIG. 7 is enabled. This is the mission mode. The re-timer 710 is configured for saving power.

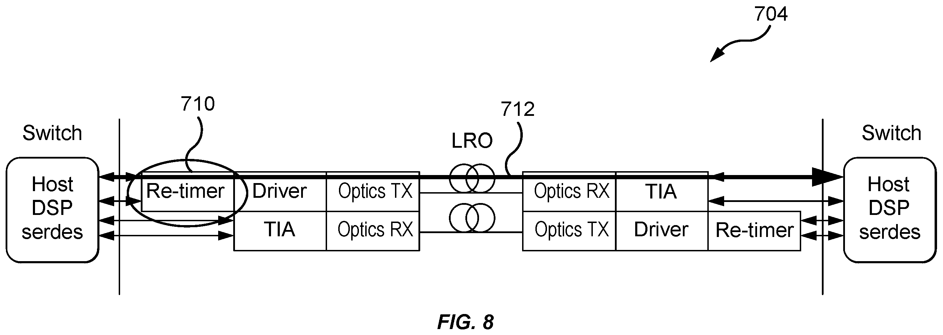

The block diagram in FIG. 7 is a detailed diagram of a DSP IC, which performs the function of the re-timer circuit. The re-timer is also shown in FIG. 8 at the system level.

FIG. 8 illustrates the LRO 704 architecture, according to an embodiment of the present disclosure. The LRO 704 comprises a re-timer 710 that is configurable as shown in FIG. 7. The enabled path 712 through the re-timer 710 enables power saving.

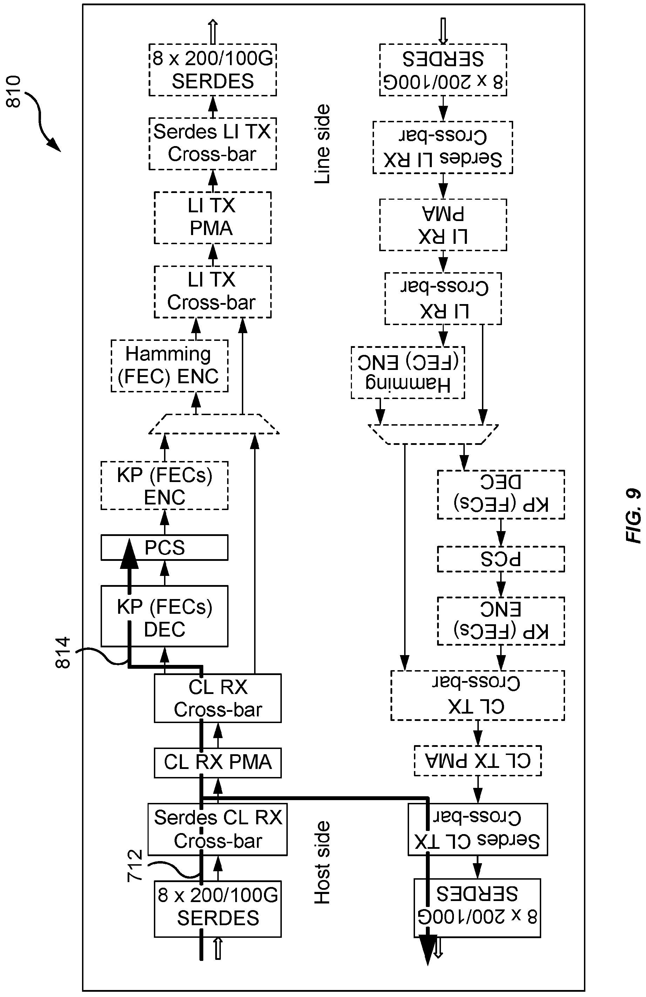

Another configuration termed as RTLR with HOST side monitoring is shown in FIG. 9. FIG. 9 illustrates a configuration of the re-timer 810, according to an embodiment of the present disclosure. In this configuration of the re-timer 810 the traffic flows through the DSP IC as in the mission mode through path 712, with the additional activation of the internal path 814 that enables FEC (Forward Error Correction) and PCS (Physical Coding Sublayer) monitoring, providing statistics on the traffic originating from the HOST device. In order to minimize the power impact of the additional enabled circuits, in a system with N modules, only one module at a time enables this monitoring function, in a round robin fashion. Like in FIG. 7, in FIG. 9 the dotted boxes indicate circuits that are powered down or in low power mode.

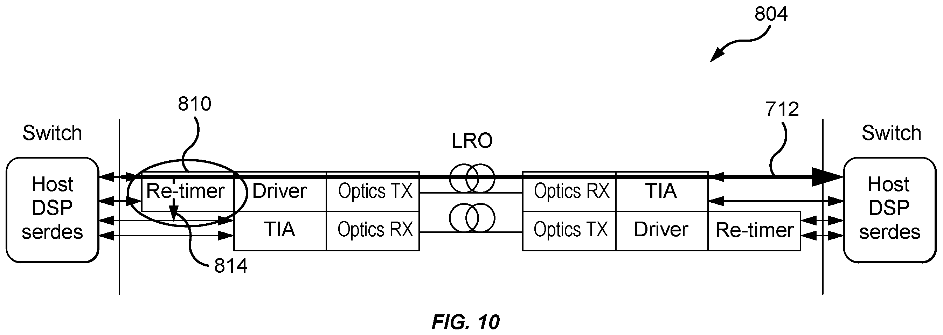

FIG. 10 illustrates the enabled paths through the re-timer in the LRO architecture, according to an embodiment of the present disclosure. The LRO 804 architecture illustrates the paths 712 and 814 through the re-timer 810. This configuration of the re-timer 810 enables HOST side monitoring.

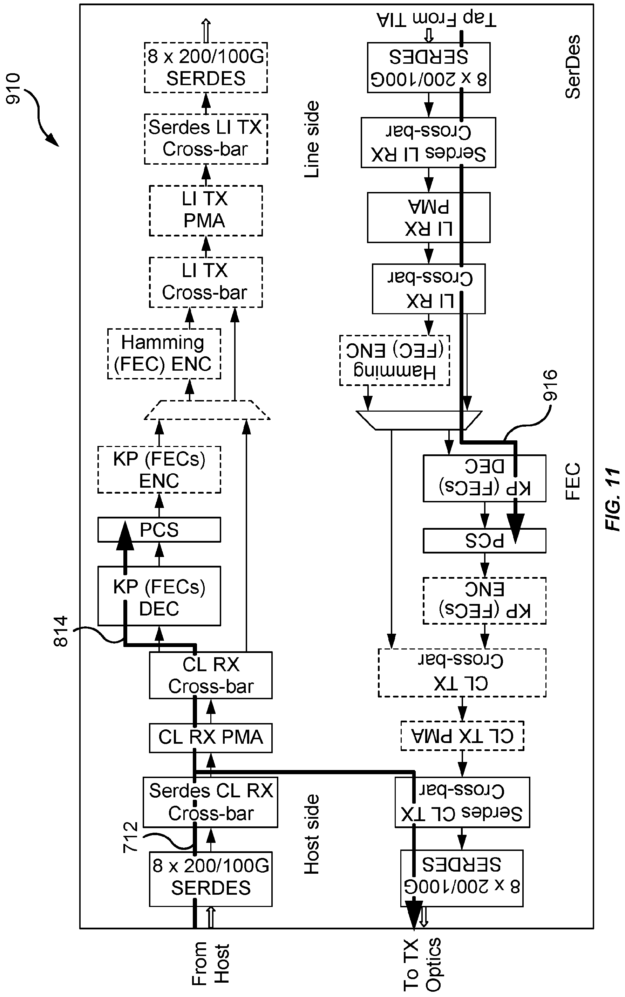

FIG. 11 illustrates a re-timer configured for HOST side and line side monitoring, according to an embodiment of the present disclosure. This configuration of the re-timer 910 adds the line side monitoring in path 916 and paths 712 and 814 are also still enabled. This is termed as RTLR with HOST side and Line side Monitoring. In this case the traffic from the receive path is branched from the TIA, which provides a "Tap" signal that is connected to the Line input side of the DSP IC. This enables enhanced FEC and PCS monitoring of the line side, providing statistics on the traffic arriving at the network.

In order to minimize the power impact of the additional enabled circuits, in a system with N modules, only one module at a time enables this Monitoring function, in a round robin fashion. This sequence can be for example under control of the HOST software system. Like in FIG. 7, in FIG. 11 the dotted boxes indicate circuits that are powered down or in low power mode.

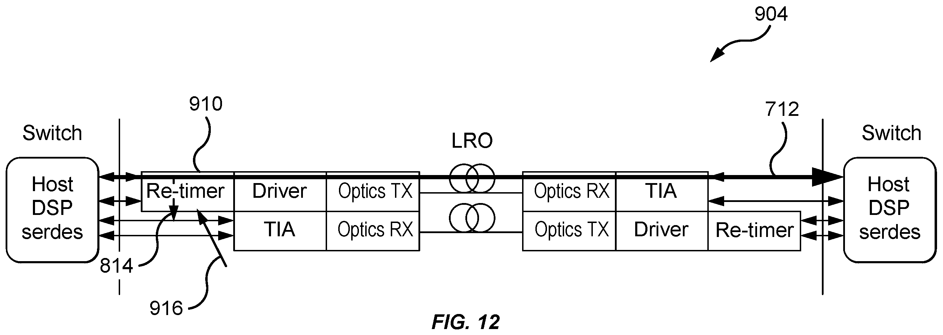

FIG. 12 illustrates the LRO architecture of HOST side and line side monitoring, according to an embodiment of the present disclosure. The LRO 904 comprises the re-timer 910 enabled for HOST side and line side monitoring through the paths 712, 814, and 916.

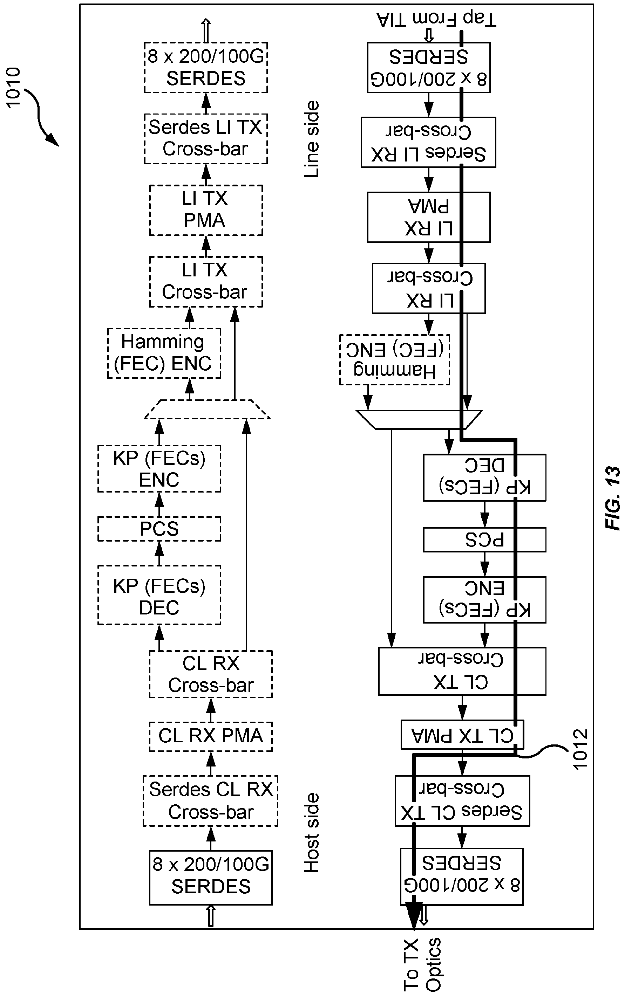

Figure 13 illustrates a line loopback configuration of the re-timer, according to an embodiment of the present disclosure. The re-timer 1010 is configured for advanced diagnostic capability. When the path 1012 is enabled, it provides a line loopback capability, which enhances debug visibility while attempting to find the root cause of a potential problem. The receive traffic (from the optical line) is looped back towards the line optical transmitter, for fault isolation purposes. Advanced diagnostic capabilities may include, but is not limited to, reporting SNR (Signal to Noise Ratio), MPI (Multi Path Interference) detection, reporting line side alarms (e.g. RX Loss Of Lock, RX Loss Of Signal), and monitoring FEC statistics. Like in FIG. 7, in FIG. 13 the dotted boxes indicate circuits that are powered down or in low power mode.

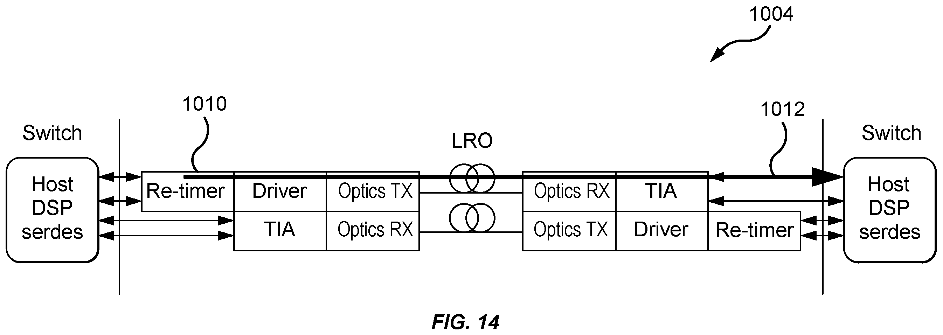

FIG. 14 illustrates the LRO architecture of line loopback configuration, according to an embodiment of the present disclosure. The LRO 1004 illustrates the re-timer 1010 and the path 1012 enabled by the re-timer 1010.

The disclosure provides the following advantages: reduced system power vs the fully retimed architecture, enhanced monitoring and debug capabilities in the optical module for the traffic signals originating from the HOST device, enhanced monitoring and debug capabilities in the optical module for the traffic signals received in the module from the line optical connection, and a line (network) loopback capability for enhanced debug and fault isolation for system operators.

Having thus described several aspects and embodiments of the technology of this application, it is to be appreciated that various alterations, modifications, and improvements will readily occur to those of ordinary skill in the art. Such alterations, modifications, and improvements are intended to be within the scope of the technology described in the application. It is, therefore, to be understood that the foregoing embodiments are presented by way of example only and that, within the scope of the appended claims and equivalents thereto, inventive embodiments may be practiced otherwise than as specifically described. In addition, any combination of two or more features, systems, articles, materials, and/or methods described herein, if such features, systems, articles, materials, and/or methods are not mutually inconsistent, is included within the scope of the present disclosure.

In some embodiments, a device controller may be any type of controller. In certain embodiments, a microprocessor may be a device controller and run a control loop. In other embodiments, an ASIC may be a device controller and may run a control loop. In further embodiments, a device controller may be an analog circuitry. In many embodiments, a bias controller may be a device controller. In certain embodiments, a bias controller may be an analog circuitry.

In some embodiments, one or more of the embodiments described herein may be stored on a computer readable medium. In certain embodiments, a computer readable medium may be one or more memories, one or more hard drives, one or more flash drives, one or more compact disk drives, or any other type of computer readable medium. In certain embodiments, one or more of the embodiments described herein may be embodied in a computer program product that may enable a processor to execute the embodiments. In many embodiments, one or more of the embodiments described herein may be executed on at least a portion of a processor.

In most embodiments, a processor may be a physical or virtual processor. In other embodiments, a virtual processor may be spread across one or more portions of one or more physical processors. In certain embodiments, one or more of the embodiments described herein may be embodied in hardware such as a Digital Signal Processor (DSP). In certain embodiments, one or more of the embodiments herein may be executed on a DSP. One or more of the embodiments herein may be programmed into a DSP. In some embodiments, a DSP may have one or more processors and one or more memories. In certain embodiments, a DSP may have one or more computer readable storages. In many embodiments, a DSP may be a custom designed ASIC chip. In other embodiments, one or more of the embodiments stored on a computer readable medium may be loaded into a processor and executed.

Also, as described, some aspects may be embodied as one or more methods. The acts performed as part of the method may be ordered in any suitable way. Accordingly, embodiments may be constructed in which acts are performed in an order different than illustrated, which may include performing some acts simultaneously, even though shown as sequential acts in illustrative embodiments.

The phrase "and/or," as used herein in the specification and in the claims, should be understood to mean "either or both" of the elements so conjoined, i.e., elements that are conjunctively present in some cases and disjunctively present in other cases.

As used herein in the specification and in the claims, the phrase "at least one," in reference to a list of one or more elements, should be understood to mean at least one element selected from any one or more of the elements in the list of elements, but not necessarily including at least one of each and every element specifically listed within the list of elements and not excluding any combinations of elements in the list of elements. This definition also allows that elements may optionally be present other than the elements specifically identified within the list of elements to which the phrase "at least one" refers, whether related or unrelated to those elements specifically identified.

The terms "approximately" and "about" may be used to mean within ±20% of a target value in some embodiments, within ±10% of a target value in some embodiments, within ±5% of a target value in some embodiments, and yet within ±2% of a target value in some embodiments. The terms "approximately" and "about" may include the target value.

In the claims, as well as in the specification above, all transitional phrases such as "comprising," "including," "carrying," "having," "containing," "involving," "holding," "composed of," and the like are to be understood to be open-ended, i.e., to mean including but not limited to. The transitional phrases "consisting of" and "consisting essentially of" shall be closed or semi-closed transitional phrases, respectively.

Where a range or list of values is provided, each intervening value between the upper and lower limits of that range or list of values is individually contemplated and is encompassed within the disclosure as if each value were specifically enumerated herein. In addition, smaller ranges between and including the upper and lower limits of a given range are contemplated and encompassed within the disclosure. The listing of exemplary values or ranges is not a disclaimer of other values or ranges between and including the upper and lower limits of a given range.

The use of headings and sections in the application is not meant to limit the disclosure; each section can apply to any aspect, embodiment, or feature of the disclosure. Only those claims which use the words "means for" are intended to be interpreted under 35 USC 112(f). Absent a recital of "means for" in the claims, such claims should not be construed under 35 USC 112. Limitations from the specification are not intended to be read into any claims, unless such limitations are expressly included in the claims.

Embodiments disclosed herein may be embodied as a system, method or computer program product. Accordingly, embodiments may take the form of an entirely hardware embodiment, an entirely software embodiment (including firmware, resident software, micro-code, etc.) or an embodiment combining software and hardware aspects that may all generally be referred to herein as a "circuit," "module," or "system." Furthermore, embodiments may take the form of a computer program product embodied in one or more computer readable medium(s) having computer readable program code embodied thereon.

## Claims

1. An optical receiver comprising:
a photodiode;
a transimpedance amplifier, =TIA, having an input coupled to an output of the photodiode;
a variable gain stage coupled to an output of the TIA, the variable gain stage comprising a plurality of variable gain amplifiers;
a first output buffer coupled to the variable gain stage to output a signal to a first module; and
a second output buffer coupled to the variable gain stage to output the signal to a second module.

2. The optical receiver of claim 1, wherein the photodiode comprises a first end coupled to the TIA,
optionally wherein the photodiode comprises a second end coupled to the TIA.

3. The optical receiver of any preceding claim, wherein any one or more of:
A) the first module is a HOST serializer/deserializer;
B) the second module is a re-timer;
C) the second module comprises a digital signal processor, DSP, to sample the signal from the second output buffer.;
D) the optical receiver does not comprise a re-timer.

4. The optical receiver of any preceding claim, comprising a voltage source and a switch coupled between the second output buffer and the voltage source, wherein the switch is configured to switch the second output buffer on and off, optionally wherein turning on and off the second output buffer does not introduce bit errors in mission mode.

5. A linear receiver pluggable optics, LRO, module comprising:
a receiver configured to connect to a remote transmitter, the receiver comprising:
a photodiode to receive an optical signal;
a transimpedance amplifier, TIA, module coupled to an output of the photodiode to transform the optical signal to an electrical signal, wherein the TIA module comprises:
a first output to output a signal to a HOST serializer/deserializer, SerDes; and
a second output to output the signal to a digital signal processor, DSP, module.

6. The LRO module of claim 5 comprising:
a transmitter to receive the electrical signal, the transmitter comprising:
the DSP module;
a driver to drive a modulator in the module; and
a modulator coupled to an output of the driver, wherein the modulator is configured to output the optical signal,
the LRO module optionally comprising:
a first test point coupled between the driver and the DSP module;
a second test point coupled to an output of the modulator;
a third test point coupled to an input of the photodiode; and
a fourth test point coupled to an output of the TIA.

7. The LRO module of claim 5 or 6, wherein the DSP module comprises a transmitter re-timer and a receiver re-timer, wherein the receiver re-timer is configured to be turned on and off, wherein the receiver re-timer is coupled to the second output of the TIA.

8. The LRO module of claim 7, wherein turning the receiver re-timer on and off does not introduce bit errors in mission mode.

9. The LRO module of claim 8, wherein the photodiode comprises a second end coupled to the TIA.

10. The LRO module of any of claims 5 to 9, wherein turning the receiver re-timer on enables receiver advanced monitoring functions from the DSP.

11. The LRO module of any of claims 5 to 10, wherein the TIA module comprises:
a transimpedance amplifier (TIA) coupled to an output of the photodiode;
a variable gain stage coupled to the output of the TIA, the variable gain stage comprising a plurality of variable gain amplifiers;
a first output buffer coupled between the variable gain stage and the first output; and
a second output buffer coupled between the variable gain stage and the second output.

12. The LRO module of claim 11, comprising a voltage source and a switch coupled between the second output buffer and the voltage source, wherein the switch is configured to switch the second output buffer on and off, wherein the switch does not introduce bit errors in mission mode.

13. The LRO module of any of claim 5 to 12, wherein the photodiode comprises a first end coupled to the TIA.

14. The LRO module of any of claims 5 to 13, wherein the receiver does not comprise a re-timer.
